# EUROPEAN PATENT SPECIFICATION

(11) **EP 3 255 487 B1**
(45) Date of publication and mention of the grant of the patent: **20.10.2021**
(21) Application number: 15880864.2
(22) Date of filing: 16.07.2015
(51) Int. Cl.: G02F 1/1333, G02F 1/1345, G06F 3/041, H05K 1/11, H04N 13/00, H01R 12/00, H01R 12/50, H05K 3/32, G02B 27/00

(54) **DISPLAY APPARATUS AND MANUFACTURING METHOD THEREOF**
ANZEIGEVORRICHTUNG UND HERSTELLUNGSVERFAHREN DAFÜR
APPAREIL D'AFFICHAGE ET SON PROCÉDÉ DE FABRICATION

(30) Priority: 06.02.2015 CN 201510064932
(43) Date of publication of application: 13.12.2017
(73) Proprietor: BOE Technology Group Co., Ltd., Beijing 100015 (CN); Beijing BOE Optoelectronics Technology Co., Ltd., Beijing 100176 (CN)
(72) Inventor: YANG, Ming, Beijing 100176 (CN); ZHAO, Wenqing, Beijing 100176 (CN); DONG, Xue, Beijing 100176 (CN); GUO, Renwei, Beijing 100176 (CN); YANG, Dong, Beijing 100176 (CN)
(74) Representative: Gesthuysen Patentanwälte
(86) International application number: PCT/CN2015/084238
(87) International publication number: WO 2016/123911

(56) References cited:
- CN-A- 102 695 364
- CN-A- 103 116 233
- CN-A- 103 904 096
- CN-A- 103 926 736
- CN-A- 104 049 802
- CN-A- 104 570 518
- JP-A- 2009 199 107
- US-A1- 2011 102 719
- US-A1- 2011 304 564
- US-A1- 2012 235 948
- US-A1- 2014 375 907

## Description

### FIELD OF THE INVENTION

The present invention relates to the display technical field, particularly to a display apparatus and a manufacturing method thereof.

### BACKGROUND OF THE INVENTION

In recent years, with the fast development of display technology, touch control display technology, three-dimensional display technology, and electrochromic display technology are also rapidly developed. Generally, it is usually required to set a flexible printed circuit board (FPC) on an out-cell device such as a touch control device, an auxiliary device for three-dimensional display and an electrochromic device in an existing display apparatus, which is electrically connected to a flexible printed circuit board on the display panel, to enable conduction between the out-cell device and an external signal and finally realize the normal display function of the display apparatus.

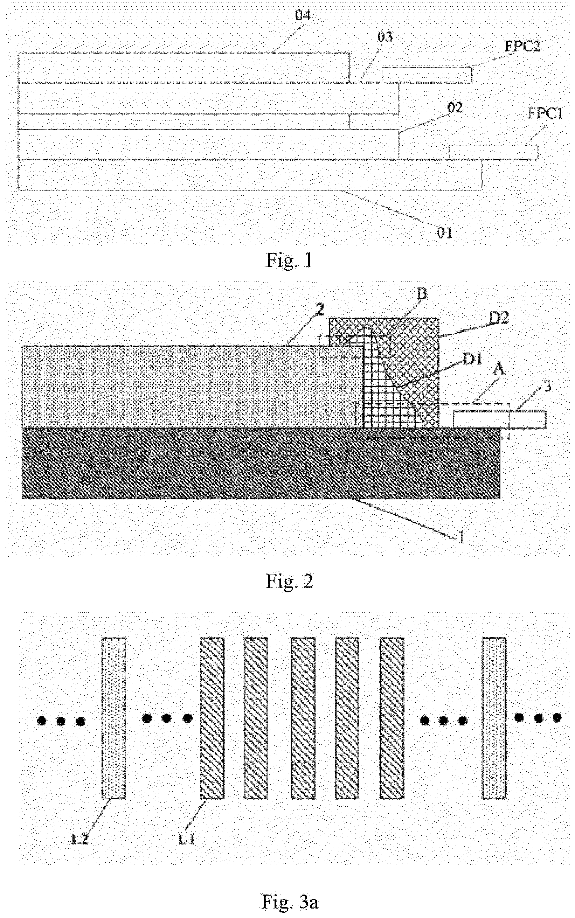

However, in some cases, a small number of signal channels are required by the flexible printed circuit board connected to the out-cell device in the display apparatus. For example, referring to Fig. 1, a naked-eye three-dimensional liquid crystal display is taken as an example. The display panel of the display mainly comprises a first substrate 01, a second substrate 02 and a liquid crystal layer (not shown) sandwiched between the first substrate 01 and the second substrate 02. A liquid crystal barrier as the out-cell device of the display mainly comprises a third substrate 03, a fourth substrate 04 and a liquid crystal layer (not shown) sandwiched between the third substrate 03 and the fourth substrate 04. Furthermore, the display panel and the out-cell device are both provided with their respective FPCs, i.e., an FPC1 electrically connected to the first substrate 01 and an FPC2 electrically connected to the third substrate 03, as shown in Fig. 1. However, with respect to such out-cell liquid crystal barrier, in order to achieve black-white display effect, only two electrode signal channels are usually required to obtain stripes alternating between brightness and darkness, thereby realizing three-dimensional display effect. However, the display structure as shown in Fig. 1 needs to additionally make an FPC2 connected to the liquid crystal barrier for three-dimensional display. This would cause an increase in the cost of manufacturing the display and does not facilitate simplification of the structure of the out-cell device.

CN104049802A discloses such as in Figures 2-3 thereof a touch display apparatus 200, comprising a first substrate 201, a second substrate 202, a display medium layer 203, a flexible circuit board 207, a bonding layer 209, a conductive structure 210 and a driving IC 205, wherein the touch display apparatus 200 further comprises a first electrode lead 206 and a second electrode lead 202a connected to the first electrode lead 206, and the first electrode lead 206 comprises a first sub-pin part 206a electrically connected with the second electrode lead 202a and a second sub-pin part 206b. Further, as shown in Figure 5 of CN104049802A, the flexible circuit board 207 comprises a first flexible circuit board electrically connected with the first sub-pin part 206a of the first electrode lead 206 and a second flexible circuit board electrically connected with the second sub-pin part 206b of the second electrode lead 206.

US 2012/0235948A1 discloses such as in Figure 15 thereof a liquid crystal device, comprising a liquid crystal panel 331, a touch panel 350 and a flexible substrate 640, wherein the flexible substrate 640 comprises two folded sections 645, 646, where a rear surface of the end 642A is connected to the touch panel terminal section 50A of the touch panel 350 through ACF 43B, a front surface of the middle portion 647 is connected to the connecting terminal section 332A through ACF 42B, and the touch panel driver 22 is connected to the front surface of the flexible substrate 640 through ACF 22B.

US2014/375907A1 discloses such as in Figures 3E-3F thereof a first substrate, a second substrate, a touch electrode unit 33 and at least one conducting unit 34. The touch display panel 3d has the conducting units 34 disposed on two neighboring sides of the first substrate 31 to electrically connect the electrodes of the touch electrode unit 33 with different directions to the conductive pattern layer 321. Furthermore, the conducting units 34 on two sides of the first substrate 31 are electrically connected to the touch control IC 38 through the patterned electrodes 3211 and the electrical connection members 39, respectively.

JP 2009199107A discloses such as in [0014] thereof that the touch-panel lateral electrode 2 and the TFT board substrate lateral electrode 6 are electrically connected by the electrically conductive paste 7. One may use a conductive ink, a conductive resin, and a conductive adhesive as the electrically conductive paste 7 here.Therefore, on the premise of guaranteeing the conduction between the out-cell device in the display apparatus and the external signal, how to simplify the structure of the out-cell device and reduce the cost of manufacturing the display apparatus are problems to be solved by those skilled in the art.

### SUMMARY OF THE INVENTION

The embodiments of the present invention provide a display apparatus and a manufacturing method thereof, for solving the problems existing in the prior art that the out-cell device of the display apparatus is complex in structure and high in the cost of production.

The embodiments of the present invention provide a display apparatus, comprising a display device, an out-cell device, and a flexible printed circuit board for being connected to an external signal; wherein,
the out-cell device (2) is an auxiliary device for three-dimensional display, a touch control device or an electrochromic device;
a binding area of the display device has first leads and second leads;
a binding area of the out-cell device has third leads, and the third leads are electrically connected to the second leads;
the flexible printed circuit board has first pins and second pins, the first leads are electrically connected to the first pins, and the second leads are electrically connected to the second pins;
the third leads are electrically connected to the second leads (L2) via a conductive glue (D1); and
the conductive glue (D1) is further covered with a layer of protective glue (D2).

In one possible embodiment, in the aforesaid display apparatus as provided in the embodiments of the present invention, the conductive glue is a silver adhesive.

In one possible embodiment, in the aforesaid display apparatus as provided in the embodiments of the present invention, in the binding area of the display device, the first leads and the second leads are arranged in parallel, and the second leads are located at two sides or one side of the first leads.

In one possible embodiment, in the aforesaid display apparatus as provided in the embodiments of the present invention, the auxiliary device for three-dimensional display is a liquid crystal barrier, an electrochromic grating or a liquid crystal lens.

In one possible embodiment, in the aforesaid display apparatus as provided in the embodiments of the present invention, the out-cell device comprises a transparent electrode, and the transparent electrode is an interdigitated structure or a laminated structure.

The embodiments of the present invention further provide a method for manufacturing the aforesaid display apparatus, wherein the out-cell device is an auxiliary device for three-dimensional display, a touch control device or an electrochromic device, the method comprising:
forming, in the binding area of the display device, first leads and second leads;
forming, in the binding area of the out-cell device, third leads;
electrically connecting the third leads of the out-cell device to the second leads of the display device using a conductive glue (D1); and
electrically connecting the first leads of the display device to the first pins of the flexible printed circuit board, and electrically connecting the second leads of the display device to the second pins of the flexible printed circuit board; and
after electrically connecting the third leads of the out-cell device to the second leads of the display device using a conductive glue, coating a layer of protective glue on the conductive glue.

The beneficial effects of the embodiments of the present invention are discussed as follows.

The embodiments of the present invention provide a display apparatus and a manufacturing method thereof. The display apparatus comprises a display device, an out-cell device and a flexible printed circuit board for being connected to an external signal; wherein a binding area of the display device has first leads and second leads; a binding area of the out-cell device has third leads, and the third leads are electrically connected to the second leads; and the flexible printed circuit board has first pins and second pins, the first leads are electrically connected to the first pins, and the second leads are electrically connected to the second pins. The third leads are electrically connected to the second leads via a conductive glue, and the conductive glue is further covered with a layer of protective glue. In this way, the third leads of the out-cell device are electrically connected to the second leads of the display device, while the second leads are electrically connected to the second pins of the flexible printed circuit board, thereby enabling conduction between the out-cell device and the external signal. As compared with the prior art in which the out-cell device and the display device are provided with their respective flexible printed circuit boards, the display apparatus as provided in the embodiments of the present invention omits the step of separately making a flexible printed circuit board of the out-cell device, thereby reducing the cost of production of the display apparatus and at the same time further simplifying the structure of the out-cell device of the display apparatus. Covering a layer of protective glue on the conductive glue can prevent the conductive glue from falling off by accident due to direct contact during the processes of manufacturing the display apparatus, thereby ensuring the electrical connection between the third leads of the out-cell device and the second leads of the display device and thus ensuring conduction between the out-cell device and the external signal.

### BRIEF DESCRIPTION OF THE DRAWINGS

Figure 1 is a schematic diagram of the structure of a three-dimensional liquid crystal display in the prior art.
Figure 2 is a schematic diagram of the structure of a display apparatus as provided in the embodiments of the present invention.
Figures 3a and 3b are schematic diagrams of the distribution of first leads and second leads as provided in the embodiments of the present invention.
Figures 4a to 4c are schematic diagrams of the structures of an electrochromic grating as provided in the embodiments of the present invention.
Figure 5 is a flow chart of a method for manufacturing a display apparatus as provided in the embodiments of the present invention.

### DETAILED DESCRIPTION OF THE INVENTION

Specific embodiments of the display apparatus and the manufacturing method thereof as provided in the embodiments of the present invention will be set forth in detail as follows in combination with the figures.

The embodiments of the present invention provide a display apparatus, which may specifically comprise, as shown in Figure 2, a display device 1, an out-cell device 2 and a flexible printed circuit board 3 for being connected to an external signal; wherein,
the out-cell device 2 is an auxiliary device for three-dimensional display, a touch control device or an electrochromic device;
a binding area of the display device 1 has first leads and second leads;
a binding area of the out-cell device 2 has third leads, and the third leads are electrically connected to the second leads via a conductive glue D1; and
the flexible printed circuit board 3 has first pins and second pins, the first leads are electrically connected to the first pins, and the second leads are electrically connected to the second pins; and
the conductive glue D1 is further covered with a layer of protective glue D2.

The aforesaid display apparatus as provided in the embodiments of the present invention comprises a display device 1, an out-cell device 2 and a flexible printed circuit board 3 for being connected to an external signal; wherein a binding area (an area marked with the dashed frame A) of the display device 1 has first leads and second leads (not shown); a binding area (an area marked with the dashed frame B) of the out-cell device 2 has third leads (not shown), and the third leads are electrically connected to the second leads ( as shown in Figure 2, they are electrically connected via a conductive glue D1); and the flexible printed circuit board 3 has first pins and second pins, the first leads are electrically connected to the first pins, and the second leads are electrically connected to the second pins. In this way, the third leads of the out-cell device 2 are electrically connected to the second leads of the display device 1 via the conductive glue, while the second leads are electrically connected to the second pins of the flexible printed circuit board 3, thereby enabling conduction between the out-cell device 2 and the external signal. As compared with the prior art in which the out-cell device and the display device are provided with their respective flexible printed circuit boards, the display apparatus as provided in the embodiments of the present invention omits the step of separately making a flexible printed circuit board of the out-cell device, thereby reducing the cost of production of the display apparatus and at the same time further simplifying the structure of the out-cell device of the display apparatus.

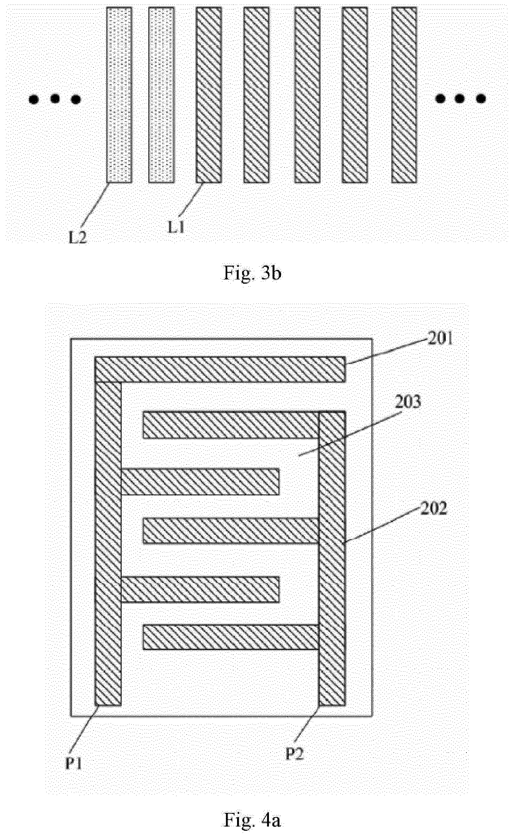

Upon implementation, in the aforesaid display apparatus as provided in the embodiments of the present invention, as shown in Figures 3a and 3b, in the binding area of the display device, the first leads L1 and the second leads L2 can be arranged in parallel, and the second leads L2 are located at two sides or one side of the first leads L1. Namely, it is possible to set the second leads L2, as shown in Figure 3a, at two sides of the first leads L1. And it is also possible to set the second leads L2, as shown in Figure 3b, at one side of the first leads L1. Specifically, the first leads L1 and the second leads L2 may also be arranged in any other suitable manner, which is not defined here. In this way, by arranging the first leads L1 and the second leads L2 in parallel and setting the second leads L2 at two sides or one side of the first leads L1, it is advantageous to differentiation between these two categories of leads and to facilitate coating of the conductive glue. Namely, when coating the conductive glue on the second leads L2, it is easy to find the positions of the second leads L2, and this facilitates coating of the conductive glue.

In the aforesaid display apparatus as provided in the embodiments of the present invention, in order to prevent the conductive glue from falling off by accident during the subsequent processes of manufacturing the display apparatus to thereby affect conduction between the out-cell device and the external signal, the conductive glue D1 is further covered with a layer of protective glue D2, as shown in Figure 2. In this way, covering a layer of protective glue D2 on the conductive glue D1 can prevent the conductive glue D1 from falling off by accident due to direct contact during the processes of manufacturing the display apparatus, thereby ensuring the electrical connection between the third leads of the out-cell device and the second leads of the display device and thus ensuring conduction between the out-cell device and the external signal.

Upon implementation, in the aforesaid display apparatus as provided in the embodiments of the present invention, in order to achieve conduction between the out-cell device and the external signal, it is required to electrically connect the third leads of the out-cell device and the second leads of the display device. According to the invention and as provided in the embodiments of the present invention, the third leads of the out-cell device are electrically connected to the second leads of the display panel by virtue of the conductive glue coating technology. It is noted that the conductive glue is one kind of metal adhesives capable of realizing the conductive glue coating technology.

Preferably, the conductive glue may be a silver adhesive, because the silver adhesive has good conductivity and facilitates signal transmission between leads.

Upon implementation, in the aforesaid display apparatus as provided in the embodiments of the present invention, the out-cell device may be an auxiliary device for three-dimensional display, a touch control device or an electrochromic device. Third leads can be set for different types of out-cell devices. However, conduction between the out-cell device and the external signal can be realized by electrically connecting the third leads of the out-cell device to the second leads of the display device via the conductive glue. As compared with the prior art in which the out-cell device and the display device are provided with their respective flexible printed circuit boards, the display apparatus as provided in the embodiments of the present invention omits the step of separately making a flexible printed circuit board of the out-cell device, thereby reducing the cost of production of the display apparatus and at the same time further simplifying the structure of the out-cell device of the display apparatus.

Upon implementation, the aforesaid display apparatus as provided in the embodiments of the present invention may be a three-dimensional display, and the corresponding auxiliary devices for three-dimensional display may be a liquid crystal barrier (LC barrier), an electrochromic grating or a liquid crystal lens (LC lens). The aforesaid display apparatus as provided in the embodiments of the present invention may also be applied in any product or component having a display function, such as mobile phone, tablet computer, television, display, notebook computer, digital frame, navigator, and so on. Namely, it can be applied in various display products based on practical needs, which is not defined here. Upon implementation, in the aforesaid display apparatus as provided in the embodiments of the present invention, the out-cell device comprises a transparent electrode, which may be an interdigitated structure or a laminated structure. Specifically, an electrochromic grating as the out-cell device will be illustrated as an example as follows. As shown in Figure 4a, the electrochromic grating comprises two transparent comb-like electrodes 201 and 202 that form an interdigitated structure, and an electrochromic material 203 filled in gaps between the two comb-like electrodes. Specifically, two ends P1 and P2 of the two separate comb-like electrodes may serve as third lead terminals of the out-cell device. Conduction between the out-cell device and the external signal is realized by electrically connecting the third lead terminals to the second leads of the display device via the conductive glue. An electric field is formed between the comb-like electrodes by applying positive and negative voltage signals to the two ends P1 and P2 of the two separate comb-like electrodes, such that the electrochromic material filled in gaps between the two comb-like electrodes can change its color under the effect of the electric field, thereby enabling display of different colors and finally achieving the normal display function of the electrochromic grating.

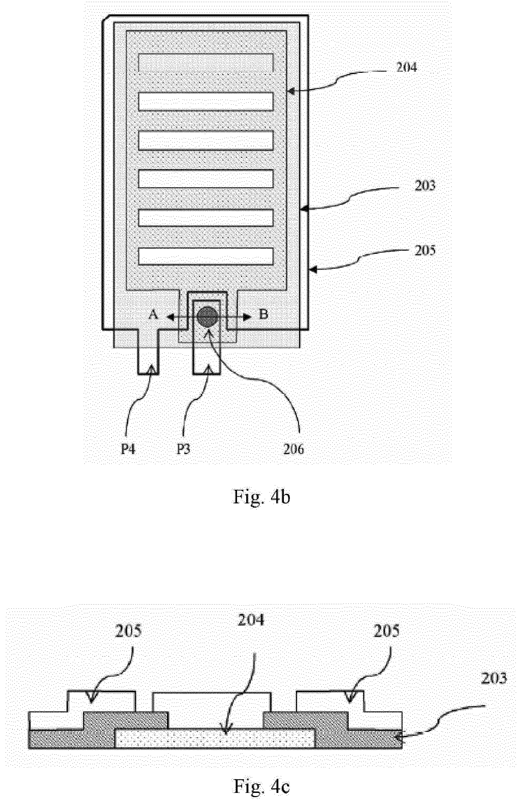

Specifically, the electrochromic grating may also be the laminated structure as shown in Figure 4b, wherein the electrochromic grating comprises a first transparent electrode 204 and a second transparent electrode 205, and an electrochromic material 203 filled between the two transparent electrodes. Two ends P3 and P4 of the two separate transparent electrodes may serve as third lead ends of the out-cell device. Electrically connecting the third lead ends to the second leads of the display device via a conductive glue enables conduction between the out-cell device and the external signal. An electric field is formed between the two transparent electrodes by applying positive and negative voltage signals to the two ends P3 and P4 of the two separate transparent electrodes, such that the electrochromic material filled between the two transparent electrodes can change its color under the effect of the electric field, thereby realizing display of different colors and finally achieving the normal display function of the electrochromic grating. In addition, in the transparent electrodes of a laminated structure, different from the transparent electrodes of an interdigitated structure, it is required to form a through hole 206 on the electrochromic material 203 between the two transparent electrodes in order to enable conduction between the third lead end P3 of the first transparent electrode 204 and the first transparent electrode 204. Figure 4c shows a cross-sectional diagram of the transparent electrode layers of a laminated structure along the cut direction AB as shown in Figure 4b.

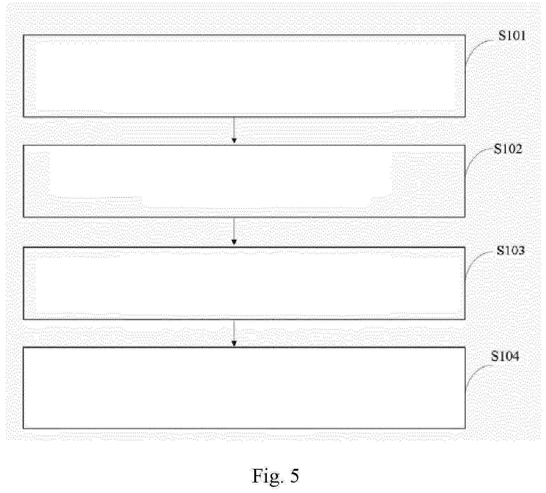

The embodiments of the present invention provide a method for manufacturing the aforesaid display apparatus. The out-cell device is an auxiliary device for three-dimensional display, a touch control device or an electrochromic device. As shown in Figure 5, the method may specifically comprise the steps of:
S101 forming, in the binding area of the display device, first leads and second leads;
S102 forming, in the binding area of the out-cell device, third leads;
S103 electrically connecting the third leads of the out-cell device to the second leads of the display device using a conductive glue; and
S104 electrically connecting the first leads of the display device to the first pins of the flexible printed circuit board, and electrically connecting the second leads of the display device to the second pins of the flexible printed circuit board; and
S105 after electrically connecting the third leads of the out-cell device to the second leads of the display device using a conductive glue, coating a layer of protective glue on the conductive glue.

In the method for manufacturing the display apparatus as provided in the embodiments of the present invention, first leads and second leads are set in the binding area of the display device; third leads are set in the binding area of the out-cell device; the third leads of the out-cell device are electrically connected to the second leads of the display device the electrical connection is realized using a conductive glue); the first leads of the display device are electrically connected to the first pins of the flexible printed circuit board; and the second leads of the display device are electrically connected to the second pins of the flexible printed circuit board. In this way, the third leads of the out-cell device are electrically connected to the second leads of the display device via the conductive glue, while the second leads are electrically connected to the second pins of the flexible printed circuit board, thereby realizing conduction between the out-cell device and the external signal. As compared with the prior art in which the out-cell device and the display device are provided with their respective flexible printed circuit boards, the display apparatus as provided in the embodiments of the present invention omits the step of separately making a flexible printed circuit board of the out-cell device, thereby reducing the cost of production of the display apparatus and at the same time further simplifying the structure of the out-cell device of the display apparatus.

In the method for manufacturing the display apparatus as provided in the embodiments of the present invention, in order to prevent the conductive glue from falling off by accident during the subsequent processes of manufacturing the display apparatus to thereby affect conduction between the out-cell device and the external signal, it comprises the step of: coating a layer of protective glue on the conductive glue after electrically connecting the third leads of the out-cell device to the second leads of the display device using the conductive glue. In this way, covering a layer of protective glue on the conductive glue can prevent the conductive glue from falling off by accident due to direct contact during the processes of manufacturing the display apparatus, thereby ensuring the electrical connection between the third leads of the out-cell device and the second leads of the display device and thus ensuring conduction between the out-cell device and the external signal.

The embodiments of the present invention provide a display apparatus and a manufacturing method thereof. The display apparatus comprises a display device, an out-cell device and a flexible printed circuit board for being connected to an external signal; wherein a binding area of the display device has first leads and second leads; a binding area of the out-cell device has third leads, and the third leads are electrically connected to the second leads; and the flexible printed circuit board has first pins and second pins, the first leads are electrically connected to the first pins, and the second leads are electrically connected to the second pins. The third leads are electrically connected to the second leads via a conductive glue, and the conductive glue is further covered with a layer of protective glue. In this way, the third leads of the out-cell device are electrically connected to the second leads of the display device, while the second leads are electrically connected to the second pins of the flexible printed circuit board, thereby enabling conduction between the out-cell device and the external signal. As compared with the prior art in which the out-cell device and the display device are provided with their respective flexible printed circuit boards, the display apparatus as provided in the embodiments of the present invention omits the step of separately making a flexible printed circuit board of the out-cell device, thereby reducing the cost of production of the display apparatus and at the same time further simplifying the structure of the out-cell device of the display apparatus. Covering a layer of protective glue on the conductive glue can prevent the conductive glue from falling off by accident due to direct contact during the processes of manufacturing the display apparatus, thereby ensuring the electrical connection between the third leads of the out-cell device and the second leads of the display device and thus ensuring conduction between the out-cell device and the external signal.

## Claims

1. A display apparatus, comprising a display device (1), an out-cell device (2) and a flexible printed circuit board (3) adapted to be connected to
an external signal; wherein,
the out-cell device (2) is an auxiliary device for realizing a three-dimensional display effect,
a touch control device or an electrochromic device;
a binding area of the display device (1) has first leads (L1) and second leads (L2);
a binding area of the out-cell device (2) has third leads, the third leads being electrically connected to the second leads (L2);
the flexible printed circuit board (3) has first pins and second pins, the first leads (L1) being electrically connected to the first pins, and the second leads (L2) being electrically connected to the second pins; and **characterized in that**
the third leads are electrically connected to the second leads (L2) via a conductive glue (D1),
the conductive glue (D1) being further covered with a layer of protective glue (D2).

2. The display apparatus according to claim 1, wherein the conductive glue (D1) is a silver adhesive.

3. The display apparatus according to claim 1, wherein in the binding area of the display device (1), the first leads (L1) and the second leads (L2) are arranged in parallel, and the second leads (L2) are located at two sides or one side of the first leads (L1).

4. The display apparatus according to claim 1, wherein the auxiliary device for realizing a three-dimensional display effect is a liquid crystal barrier, an electrochromic grating or a liquid crystal lens.

5. The display apparatus according to claim 1, wherein the out-cell device (2) comprises a transparent electrode (201, 202, 204, 205), the transparent electrode (201, 202, 204, 205) being an interdigitated structure or a laminated structure

6. A method for manufacturing the display apparatus according to any one of claims 1 to 6, the method comprising:
forming, in the binding area of the display device (1), first leads (L1) and second leads (L2);
forming, in the binding area of the out-cell device (2), third leads;
electrically connecting the third leads of the out-cell device (2) to the second leads (L2) of the display device (1) using a conductive glue (D1);
electrically connecting the first leads (L1) of the display device (1) to the first pins of the flexible printed circuit board (3), and electrically connecting the second leads (L2) of the display device (1) to the second pins of the flexible printed circuit board (3); wherein
after electrically connecting the third leads of the out-cell device (2) to the second leads (L2) of the display device (1) using a conductive glue (D1), coating a layer of protective glue (D2) on the conductive glue (D1).

## Patentansprüche

1. Anzeigevorrichtung, umfassend eine Anzeigeeinrichtung (1), eine Ausgangszelleneinrichtung (2) und eine flexible Leiterplatte (3), die dazu angepasst ist, mit einem externen Signal verbunden zu werden, wobei die Ausgangszelleneinrichtung (2) eine Hilfseinrichtung zur Realisierung eines dreidimensionalen Anzeigeeffekts, eine Berührungssteuereinrichtung oder eine elektrochrome Einrichtung ist;
ein Bindebereich der Anzeigeeinrichtung (1) erste Leitungen (L1) und zweite Leitungen (L2) aufweist;
ein Bindungsbereich der Ausgangszelleneinrichtung (2) dritte Leitungen aufweist, wobei die dritten Leitungen elektrisch mit den zweiten Leitungen (L2) verbunden sind;
die flexible Leiterplatte (3) erste Stifte und zweite Stifte aufweist, wobei die ersten Leitungen (L1) elektrisch mit den ersten Stiften verbunden sind und die zweiten Leitungen (L2) elektrisch mit den zweiten Stiften verbunden sind; und **dadurch gekennzeichnet, dass**
die dritten Leitungen mit den zweiten Leitungen (L2) über einen leitfähigen Klebstoff (D1) elektrisch verbunden sind,
der leitfähige Klebstoff (D1) ferner mit einer Schicht Schutzklebstoff (D2) bedeckt ist.

2. Anzeigevorrichtung gemäß Anspruch 1, wobei der leitfähige Klebstoff (D1) ein Silberklebstoff ist.

3. Anzeigevorrichtung gemäß Anspruch 1, wobei in dem Bindungsbereich der Anzeigeeinrichtung (1) die ersten Leitungen (L1) und die zweiten Leitungen (L2) parallel angeordnet sind und die zweiten Leitungen (L2) an zwei Seiten oder einer Seite der ersten Leitungen (L1) angeordnet sind.

4. Anzeigevorrichtung gemäß Anspruch 1, wobei die Hilfseinrichtung zur Realisierung eines dreidimensionalen Anzeigeeffekts eine Flüssigkristallbarriere, ein elektrochromes Gitter oder eine Flüssigkristalllinse ist.

5. Anzeigevorrichtung gemäß Anspruch 1, wobei die Ausgangszelleneinrichtung (2) eine transparente Elektrode (201, 202, 204, 205) umfasst, wobei die transparente Elektrode (201, 202, 204, 205) eine interdigitale Struktur oder eine laminierte Struktur ist.

6. Verfahren zur Herstellung der Anzeigeeinrichtung gemäß einem der Ansprüche 1 bis 5, wobei das Verfahren umfasst:
Bilden von ersten Leitungen (L1) und zweiten Leitungen (L2) im Bindungsbereich der Anzeigeeinrichtung (1);
Bilden von dritten Leitungen im Bindungsbereich der Ausgangszelleneinrichtung (2);
elektrisches Verbinden der dritten Leitungen der Ausgangszelleneinrichtung (2) mit den zweiten Leitungen (L2) der Anzeigeeinrichtung (1) mittels eines leitfähigen Klebstoffs (D1);
elektrisches Verbinden der ersten Leitungen (L1) der Anzeigeeinrichtung (1) mit den ersten Stiften der flexiblen Leiterplatte (3) und elektrisches Verbinden der zweiten Leitungen (L2) der Anzeigeeinrichtung (1) mit den zweiten Stiften der flexiblen Leiterplatte (3); wobei
nach dem elektrischen Verbinden der dritten Leitungen der Ausgangszelleneinrichtung (2) mit den zweiten Leitungen (L2) der Anzeigeeinrichtung (1) mittels eines leitfähigen Klebstoffs (D1) Beschichten des leitfähigen Klebstoffs (D1) mit einer Schicht aus Schutzklebstoff (D2) .

## Revendications

1. Appareil d'affichage, comportant un dispositif (1) d'affichage, un dispositif (2) de cellule externe et une carte (3) à circuit imprimé souple prévue pour être connectée à un signal externe ;
le dispositif (2) de cellule externe étant un dispositif auxiliaire servant à réaliser un effet d'affichage tridimensionnel, un dispositif à commande tactile ou un dispositif électrochromique ;
une zone de fixation du dispositif (1) d'affichage possédant des premiers conducteurs (L1) et des deuxièmes conducteurs (L2) ;
une zone de fixation du dispositif (2) de cellule externe possédant des troisièmes conducteurs, les troisièmes conducteurs étant reliés électriquement aux deuxièmes conducteurs (L2) ;
la carte (3) à circuit imprimé souple possédant des premières broches et des deuxièmes broches, les premiers conducteurs (L1) étant reliés électriquement aux premières broches, et les deuxièmes conducteurs (L2) étant reliés électriquement aux deuxièmes broches ; et
**caractérisé en ce que** les troisièmes conducteurs sont reliés électriquement aux deuxièmes conducteurs (L2) via une colle conductrice (D1), la colle conductrice (D1) étant en outre recouverte d'une couche de colle protectrice (D2).

2. Appareil d'affichage selon la revendication 1, la colle conductrice (D1) étant un adhésif à l'argent.

3. Appareil d'affichage selon la revendication 1, dans la zone de fixation du dispositif (1) d'affichage, les premiers conducteurs (L1) et les deuxièmes conducteurs (L2) étant agencés en parallèle, et les deuxièmes conducteurs (L2) étant situés de deux côtés ou d'un seul côté des premiers conducteurs (L1).

4. Appareil d'affichage selon la revendication 1, le dispositif auxiliaire qui sert à réaliser un effet d'affichage tridimensionnel étant une barrière à cristaux liquides, un réseau électrochromique ou une lentille à cristaux liquides.

5. Appareil d'affichage selon la revendication 1, le dispositif (2) de cellule externe comportant une électrode transparente (201, 202, 204, 205), l'électrode transparente (201, 202, 204, 205) étant une structure interdigitée ou une structure stratifiée.

6. Procédé de fabrication de l'appareil d'affichage selon l'une quelconque des revendications 1 à 5, le procédé comportant les étapes consistant à :
former, dans la zone de fixation du dispositif (1) d'affichage, des premiers conducteurs (L1) et des deuxièmes conducteurs (L2) ;
former, dans la zone de fixation du dispositif (2) de cellule externe, des troisièmes conducteurs ;
relier électriquement les troisièmes conducteurs du dispositif (2) de cellule externe aux deuxièmes conducteurs (L2) du dispositif (1) d'affichage à l'aide d'une colle conductrice (D1) ;
relier électriquement les premiers conducteurs (L1) du dispositif (1) d'affichage aux premières broches de la carte (3) à circuit imprimé souple, et relier électriquement les deuxièmes conducteurs (L2) du dispositif (1) d'affichage aux deuxièmes broches de la carte (3) à circuit imprimé souple ;
après avoir relié électriquement les troisièmes conducteurs du dispositif (2) de cellule externe aux deuxièmes conducteurs (L2) du dispositif (1) d'affichage à l'aide d'une colle conductrice (D1), revêtir la colle conductrice (D1) d'une couche de colle protectrice (D2).
